Europäisches Patentamt

European Patent Office

Office européen des brevets

(11) Veröffentlichungsnummer: **0 480 168 A1**

# EUROPÄISCHE PATENTANMELDUNG

(21) Anmeldenummer: **91114785.8**

(22) Anmeldetag: **03.09.91**

(51) Int. Cl.5: **H01L 21/00**

(30) Priorität: **08.10.90 DE 4031795**

(43) Veröffentlichungstag der Anmeldung:
**15.04.92 Patentblatt 92/16**

(84) Benannte Vertragsstaaten:
**AT BE CH DE DK ES FR GB GR IT LI LU NL SE**

(71) Anmelder: **Degussa Aktiengesellschaft**
**Weissfrauenstrasse 9**
**W-6000 Frankturt am Main 1(DE)**

(72) Erfinder: **Ruppel, Josef, Dipl.-Ing.**
**Lindenstrasse 11**
**W-6453 Seligenstadt(DE)**

(54) **Vorrichtung zur gleichmässigen Verteilung einer Kraft auf eine Reihe von Stapeln in einem Sinterofen.**

(57) Zum gleichmäßigen, querkraftarmen Belasten von Keramikplattenstapeln beim Sintern in Sinteröfen, wobei die Belastung über eine Traverse erfolgt, wird zwischen Stapel und Traverse eine Druckplatte eingefügt. Diese Druckplatte besteht aus einer oberen Druckplatte und einer unteren Druckplatte, wobei mindestens eine der Druckplatten knicksteife Wangen mit Aufhängungen trägt und zwischen den Aufhängungen der einen Druckplatte und der anderen Druckplatte bzw. deren Aufhängungen biegsame Verbindungselemente angebracht sind.

Fig.

Die Erfindung betrifft eine Vorrichtung zur gleichmäßigen, querkraftarmen Verteilung einer zentral zugeführten Kraft mittels einer Traverse senkrecht auf eine Reihe von auf einer Grundplatte sitzenden Stapeln aus Keramikplatten in einem Sinterofen, die aufgrund des Sintervorgangs eine Dickabnahme erfahren, wobei die Kraft von der Traverse auf die einzelnen Stapeln über Druckplatten zugeführt wird.

Bei der Herstellung von Leiterplatten aus Keramik, beispielsweise für die Computerindustrie, werden Rohlinge, die aus mehreren Schichten bestehen, in Stapeln angeordnet und in Keramiksinteröfen gesintert. Diese Stabeln werden während des Sinterns mit einer senkrecht wirkenden Kraft beaufschlagt, damit die einzelnen Schichten zusammensintern. Dabei erfahren die einzelnen Leiterplatten eine Dickenabnahme. Um ein gleichmäßiges Sintern der Leiterplatten zu gewährleisten, muß der Sinterofen während des Sintervorgangs ein möglichst einheitliches Temperaturprofil aufweisen.

Es ist bekannt, die einzelnen Stapeln von Keramikplatten getrennt zu belasten, entweder mit Gewichten oder mit einer von außen wirkenden Kraft, die genau senkrecht auf die Stapel einwirken muß, damit es nicht zu Verschiebungen der einzelnen Schichten kommt, die bereits mit Leiterbahnen versehen sein können.

Die Belastung der Stapeln mit einzelnen Gewichten hat den Nachteil, daß die Plattenstapel während des Sintervorgangs nicht entlastet werden können, die Ofenretorte durch diese Gewichte während des gesamten Sinterprozesses zusätzlich belastet wird und die Gewichte zusätzliche Speicherwärme erfordern.

Bei Zuführung der Druckkräfte auf die einzelnen Stapeln mittels von außerhalb des Ofens befindlichen Druckelementen, wie Druckzylindern, ist für jedes Druckelement eine eigene Druchführung durch den Ofen notwendig. Dieses Verfahren hat zwar den Vorteil, daß die Stapel während des Sinterns einzeln be- und entlastet werden können, andererseits aber den Nachteil, daß mehrere Ofendurchführungen notwendig sind, die das Temperaturprofil negativ beeinflussen.

Man verwendet daher zur Belastung der einzelnen Stapel Traversen, die zentral von außen mit einer Kraft beaufschlagt werden und über Arme auf den einzelnen Stapeln aus Keramikplatten aufsitzen. Dabei ist zwischen Traversenarm und Stapel eine Druckplatte angeordnet. Diese Anordnung hat den Vorteil, daß zur Zuführung der Preßkraft nur eine einzige Ofendurchführung notwendig ist. Durch einen ungleichmäßigen Dickenschwund der einzelnen Keramikplatten und Stapeln kann es aber dazu kommen, daß die Traverse schräg steht und dadurch seitliche Kräfte auf die Keramikplatten einwirken. Das ergibt aber Versetzungen der einzelnen Schichten, was zu Ausschuß führt, da solche Leiterplatten nicht mehr verwendet werden können.

Es war daher Aufgabe der vorliegenden Erfindung, eine Vorrichtung zu gleichmäßigen, querkraftarmen Verteilung einer zentral zugeführten Kraft mittels einer Traverse senkrecht auf eine Reihe von auf einer Grundplatte sitzenden Stapeln aus Keramikplatten in einem Sinterofen, die aufgrund des Sintervorgangs eine Dickenabnahme erfahren, wobei die Kraft von der Traverse auf die einzelnen Stapeln über Druckplatten zugeführt wird, zu entwickeln, bei der keine seitlichen Verschiebungen der einzelnen Keramikplattenschichten eintreten können.

Diese Aufgabe wird erfindungsgemäß dadurch gelöst, daß auf jedem Stapel zwei Druckplatten räumlich getrennt übereinander angeordnet sind, von denen die ober Druckplatte, an der in Richtung Grundplatte knicksteife Wangen angebracht sind, die am von der Druckplatte abgelegenen Ende Aufhängungen tragen, von der Traverse belastet wird, und die untere Druckplatte auf dem Stapel aufliegt, wobei zwischen der unteren Druckplatte und den Aufhängungen der oberen Druckplatte biegsame Verbindungselemente mit eckigen oder rundem Querschnitt paralell zur Stapelachse angeordnet sind, deren Länge so bemessen ist, daß die beiden Druckplatten einen räumlichen Abstand zueinander aufweisen müssen.

Vorteilhafterweise ist die untere Druckplatte in Richtung Traverse ebenfalls mit knicksteifen Wangen versehen, die am von der Druckplatte abgelegenen Ende Aufhängungen tragen, wobei die biegsamen Verbindungselemente zwischen den Aufhängungen von unterer und oberer Druckplatte angeordnet sind.

Die Wangen müssen dabei stets über die andere Druckplatte hinausragen.

Die Befestigung der biegsamen Verbindungselemente an den Aufhängungen kann starr erfolgen. Vorzugsweise sind die Verbindungselemente jedoch nicht starr befestigt, so daß sie im begrenzten Umfang axiale und seitliche Bewegungen ausführen können.

Weiterhin ist es von Vorteil, wenn zwischen den beiden Druckplatten Abstützelemente angebracht sind.

Die Verbindungselemente können aus biegsamen Stäben, Rohren oder Blechstreifen aus einem temperaturfesten Material bestehen. Vorzugsweise verwendet man geschlitzte Bleche.

Durch die erfindungsgemäße Vorrichtung wird die auf die Traverse wirkende Druckkraft in eine Zugkraft umgewandelt, die auf die einzelnen Stapel wirkt. Dadurch ist es möglich, die durch eine schrägstehende Traverse bedingte Wegeverkürzung mit Hilfe kleinster Kräfte auszugleichen. Den Wegausgleich ermöglicht das biegsame Verbindungselement zwischen oberer und unterer Druckplatte, das im Trägheitsmoment so weich wie möglich ausgelegt sein sollte.

Versetzungen der einzelnen Schichten der Keramikleiterplatten während des Sinterns werden durch diese Vorrichtung zuverlässig verhindert.

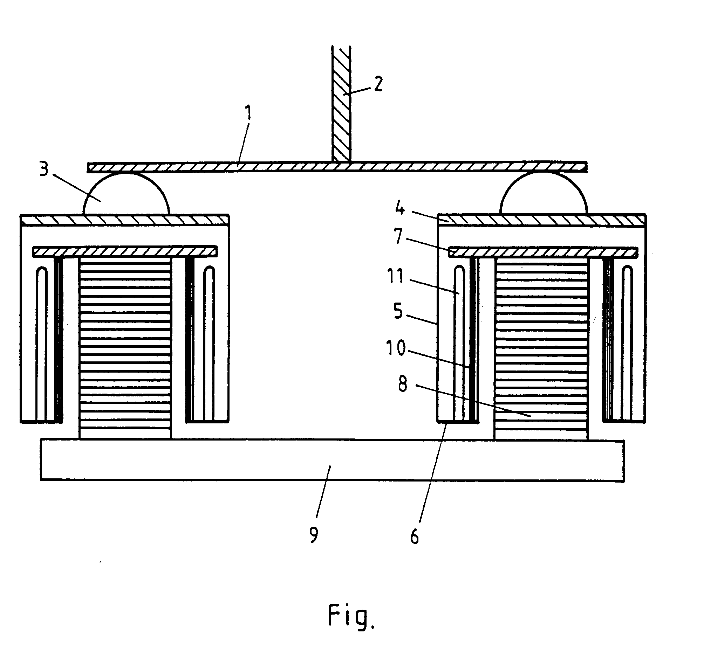

Die Abbildung zeigt schematisch eine beispielhafte Aufführungsform der erfindungsgemäßen Vorrichtung im Längsschnitt.

Die Traverse (1) wird über ein Gestänge (2) von außerhalb des Ofens mit einer Druckkraft beaufschlagt. Über Kalotten (3) ist die Traverse (1) mit der oberen Druckplatte (4) in Kontakt, an der Wangen (5) angebracht sind, die am Ende mit Aufhängungen (6) versehen sind. Die untere Druckplatte (7) liegt auf dem Stapel (8) aus Keramikplatten auf, die ihrerseits auf einer Grundplatte (9) ruhen. Zwischen der unteren Druckplatte (7) und den Aufhängungen (6) der oberen Druckplatte (4) sind paralell zur Stapelachse biegsame Verbindungselemente (10) angeordnet. Weiterhin sind zwischen der oberen Druckplatte (4) und der unteren Druckplatte (7) Abstützelemente angebracht.

**Patentansprüche**

1.  Vorrichtung zur gleichmäßigen , querkraftarmen Verteilung einer zentral zugeführten Kraft mittels einer Traverse senkrecht auf eine Reihe von auf einer Grundplatte sitzenden Stapeln aus Keramikplatten in einem Sinterofen, die aufgrund des Sintervorgangs eine Dickenabnahme erfahren, wobei die Kraft von der Traverse auf die einzelnen Stapeln über Druckplatten zugeführt wird,
    dadurch gekennzeichnet,
    daß auf jedem Stapel (8) zwei Druckplatten (4,7) räumlich getrennt übereinander angeordnet sind, von denen die obere Druckplatte (4), an der in Richtung Grundplatte (9) knicksteife Wangen (5) angebracht sind, die am von der Druckplatte (4) abgelegenen Ende Aufhängungen (6) tragen, von der Traverse (1) belastet wird,
    und die untere Druckplatte (7) auf dem Stapel (8) aufliegt, wobei zwischen der unteren Druckplatte (7) und den Aufhängungen (6) der oberen Druckplatte (4) biegsame Verbindungselemente (10) mit eckigen oder rundem Querschnitt parallel zur Stapelachse angeordnet sind, deren Länge so bemessen ist, daß die beiden Druckplatten (4,7) einen räumlichen Abstand zueinander aufweisen müssen.

2.  Vorrichtung nach Anspruch 1,
    dadurch gekennzeichnet,
    daß die untere Druckplatte (7) in Richtung Traverse (1) ebenfalls mit knicksteifen Wangen und
    Aufhängungen versehen ist,
    und die biegsamen Verbindungselemente (10) zwischen den Aufhängungen von unterer und oberer Druckplatte (4,7) angeordnet sind.

3.  Vorrichtung nach Anspruch 1 oder 2,
    dadurch gekennzeichnet,
    daß die Verbindungselemente (10) an den Aufhängungen bzw. Druckplatten nicht starr befestigt sind.

4.  Vorrichtung nach einem der Ansprüche 1 bis 3,
    dadurch gekennzeichnet,
    daß zwischen den beiden Druckplatten (4,7) Abstützelemente (11) angebracht sind.

5.  Vorrichtung nach einem der Ansprüche 1 bis 4,
    dadurch gekennzeichnet,
    daß die Verbindungselemente (10) aus geschlitzten Blechen bestehen.

Fig.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | WO-A-8 603 338   (IRVINE SENSORS CORPORATION) * Seite 6, Zeile 24 - Seite 7, Zeile 10; Anspruch 1; Abbildungen 2,3 * * | 1 | H 01 L 21/00 |
| | – – – | | |
| A | PATENT ABSTRACTS OF JAPAN no. 4056 (E-008)25. April 1980 & JP-A-55 024 486 ( NIPPON GAKKI SEIZO ) 21. Februar 1980 * Zusammenfassung * * | 1 | |
| | – – – – – | | |

|  | RECHERCHIERTE SACHGEBIETE (Int. Cl.5) |
|---|---|
| | H 01 L |
| | H 01 F |

Der vorliegende Recherchenbericht wurde für alle Patentansprüche erstellt

| Recherchenort | Abschlußdatum der Recherche | Prüfer |
|---|---|---|
| Den Haag | 03 Februar 92 | RIEUTORT A.S. |